# FASCICULE DE BREVET EUROPEEN

(11) **EP 2 726 291 B1**
(45) Date de publication et mention de la délivrance du brevet: **17.08.2016**
(21) Numéro de dépôt: 12730922.7
(22) Date de dépôt: 26.06.2012
(51) Int. Cl.: B41F 15/36, H05K 3/12

(54) **SYSTEME D'IMPRESSION SERIGRAPHIQUE POUR CELLULE PHOTOVOLTAIQUE ET PROCÉDÉS**
SIEBDRUCKSYSTEM FÜR EINE PHOTOVOLTAISCHE ZELLE UND ENTSPRECHENDE VERFAHREN
SCREEN-PRINTING SYSTEM FOR A PHOTOVOLTAIC CELL, AND RELATED METHODS

(30) Priorité: 01.07.2011 FR 1155923
(43) Date de publication de la demande: 07.05.2014
(73) Titulaire: Commissariat à l'Énergie Atomique et aux Énergies Alternatives, 75015 Paris (FR)
(72) Inventeur: BETTINELLI, Armand, F-38500 Coublevie (FR)
(74) Mandataire: Novaimo
(86) Numéro de dépôt international: PCT/EP2012/062339
(87) Numéro de publication internationale: WO 2013/004550

(56) Documents cités:
- EP-A1- 1 705 029
- DE-A1- 19 615 058
- DE-B- 1 068 277
- DE-U1-202006 006 712
- US-A- 5 606 911
- US-B1- 6 258 445

## Description

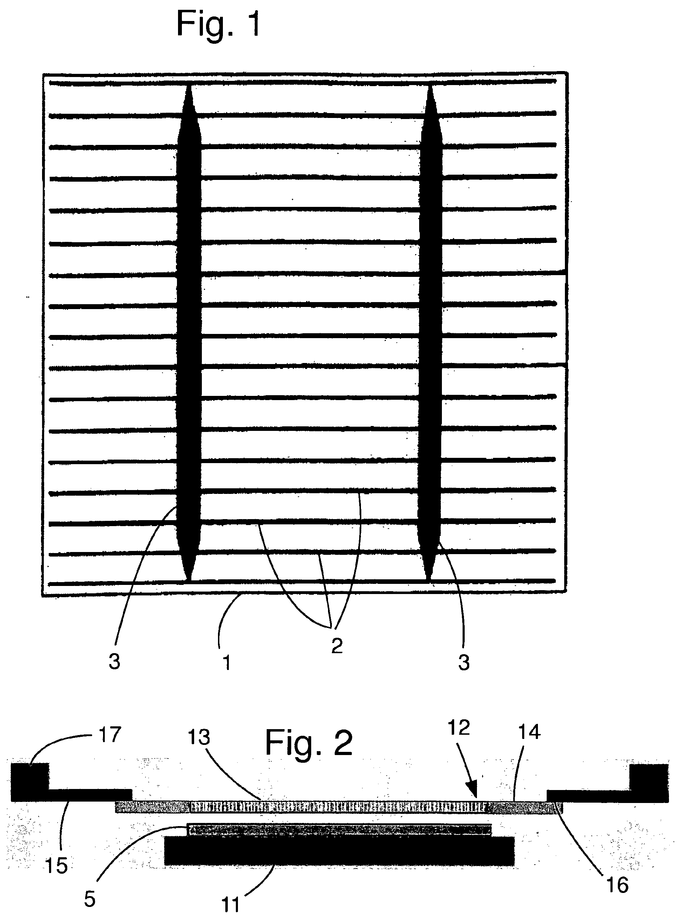

Une cellule photovoltaïque est fabriquée à l'aide d'une plaquette en matériau semi-conducteur, généralement en silicium, connue sous sa dénomination anglaise de « wafer ». Cette fabrication nécessite en particulier la formation de conducteurs électriques sur la surface de cette plaquette. La figure 1 illustre la surface d'une telle plaquette 1 selon l'état de la technique, qui comprend des premiers conducteurs parallèles de fine largeur, appelés conducteurs de collecte 2, dont la fonction est de collecter les électrons créés dans le silicium par la lumière. La surface de la plaque 1 comprend de plus d'autres conducteurs parallèles plus larges 3, parfois appelés « bus barres », orientés dans une direction perpendiculaire aux conducteurs de collecte 2, dont la fonction est de conduire des charges électriques plus élevées, de cellules photovoltaïques en cellules photovoltaïques. Ces conducteurs plus larges 3 sont reliés en général à un ruban métallique s'étendant sur toute leur longueur. Tous ces conducteurs 2, 3 sont obtenus par différentes techniques permettant de former des lignes conductrices continues, s'étendant de manière continue sur toute la longueur et la largeur de la plaque.

Pour réaliser ces conducteurs, une méthode de l'état de la technique consiste par exemple à déposer une encre conductrice par sérigraphie sur la plaquette, avec une ou deux impression(s) sérigraphique(s). Pour cela, la méthode consiste à faire traverser l'encre conductrice à travers un écran constitué d'une toile ou tissu. Cette toile est recouverte d'une couche d'étanchéité, sauf aux endroits où l'encre doit la traverser. Cette traversée est obtenue avec l'aide d'une racle qui presse l'encre à travers la toile : toutefois, les fils de la toile représentent une gêne dans cette opération, et il n'est pas possible d'obtenir une géométrie idéale des conducteurs résultants, notamment en ce qui concerne la régularité de la hauteur de la couche d'encre déposée : cette méthode ne permet pas de former des conducteurs suffisamment performants. En effet, la performance électrique de ces conducteurs est très sensible à leur géométrie, et notamment au ratio épaisseur/largeur, l'épaisseur se mesurant dans la direction verticale perpendiculaire à la plaque 1, et la largeur se mesurant dans la direction horizontale, transversale au conducteur.

Le document US6258445 décrit un pochoir qui est fixé sur une partie de son pourtour à un cadre. Ce pochoir présente une armature plastique renforcée par un dépôt métallique. Une telle approche ne permet toutefois pas d'atteindre un résultat satisfaisant.

Pour pallier à ces inconvénients, une seconde méthode de l'état de la technique consiste à remplacer la toile précédente par un pochoir métallique, ou feuillard métallique, aussi appelé par sa dénomination anglaise de « stencil », dans lequel sont réalisées des ouvertures traversantes. Toutefois, pour ne pas fragiliser ces masques métalliques et obtenir leur comportement optimal lors de l'impression, il n'est pas possible de réaliser des ouvertures de trop grande surface, et notamment pas des ouvertures qui s'étendraient sur toute la longueur ou la largeur du pochoir, et le procédé nécessite généralement au moins deux impressions, à partir de deux masques distincts complémentaires, pour obtenir les différents conducteurs illustrés sur la figure 1. Pour cette raison, ce procédé reste complexe et coûteux. De plus, comme le pochoir métallique n'a pas l'élasticité d'une toile et ne peut pas suffisamment se déformer sous l'effet d'une racle, il est associé à une toile collée en périphérie pour apporter à l'ensemble une élasticité suffisante, selon une construction appelée « trampoline ».

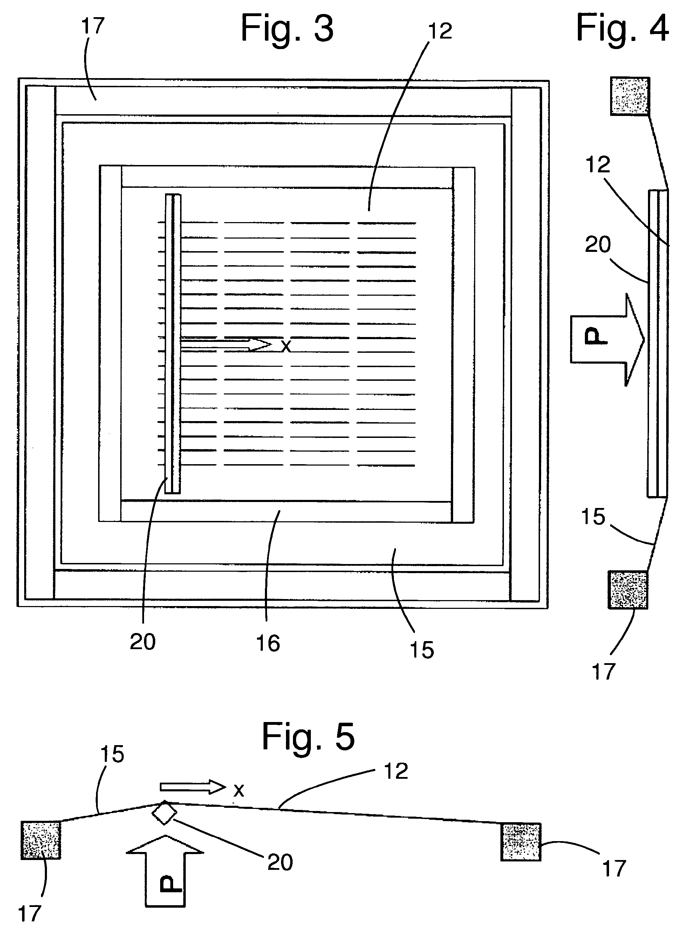

Les figures 2 à 5 représentent schématiquement une telle construction de type trampoline, appliquée à une étape d'impression sérigraphique de conducteurs à la surface d'une plaquette de silicium 5 pour former des cellules photovoltaïques. Le dispositif d'impression comprend une table d'impression 11 sur laquelle repose la plaquette de silicium 5, un pochoir métallique 12 rectangulaire comprenant une zone centrale d'impression 13 qui comprend des ouvertures destinées à être traversées par l'encre conductrice pour former les conducteurs 2, 3 de la future cellule photovoltaïque à la surface de la plaquette de silicium, comme cela a été explicité précédemment et représenté par la figure 1. Pour cela, le pochoir métallique 12 est positionné à une distance d'environ 1 mm au-dessus de la plaquette de silicium 5 à imprimer, et une racle 20 s'étendant sur toute la largeur de la plaquette de silicium 5 se déplace en translation dans une direction X sur toute la longueur de la plaquette de silicium 5, en transmettant une force de pression P comprise entre 30 N et 150 N sur la surface du pochoir métallique 12 pour le déformer et presser l'encre à travers ses ouvertures jusqu'à la surface de plaquette de silicium 5. Pour pouvoir supporter cet effort et atteindre une déformation suffisante et pour permettre le décollement du pochoir après le passage de la racle, le pochoir métallique 12 est fixé à une toile 15 sur une zone 16 de collage s'étendant sur les quatre côté de sa périphérie rectangulaire. Enfin, les quatre côtés formant le contour rectangulaire de cette toile 15 sont eux-mêmes collés à un cadre rectangulaire 17.

Malgré tout, cette méthode d'impression présente les inconvénients suivants :
- La toile exerce une tension sur le pochoir métallique qui induit sa déformation autour de ses ouvertures, notamment celles situées sur les bords. Il en résulte des impressions plus larges que souhaité, ce qui conduit à des défauts d'aspect et ce qui diminue la performance de la cellule photovoltaïque ;
- De plus, cette tension de la toile peut même induire une déformation globale plus importante du pochoir métallique, en général très fin, qui induit par exemple une courbure des lignes prévues normalement rectilignes. Les conducteurs initialement prévus sont donc déformés. De plus, la déformation s'accentue lors de la mise en oeuvre du système d'impression et plus particulièrement lors du passage de la racle. Ainsi il est très difficile de réaliser la superposition précise d'une couche d'encre sur des zones localisées, que ce soit une seconde couche d'encre conductrice déposée sur une première couche (technologie double impression) ou que ce soit une couche d'encre déposée sur une zone surdopée (technologie Emetteur sélectif), ce qui nuit à la performance de la cellule photovoltaïque.

Ces inconvénients peuvent être réduits en utilisant des cadres de plus grande taille, par exemple des cadres de 381 mm (c'est-à-dire 15 pouces) au lieu de 305 mm (c'est-à-dire 12 pouces) pour la sérigraphie de cellules de 152 mm (c'est-à-dire 6 pouces), mais cela engendre un surcoût notable.

Le document DE 1 068 277 décrit un système selon le préambule de la revendication 1.

Ainsi, un objet général de l'invention est de proposer une solution de réalisation d'un conducteur électrique sur une plaque d'un dispositif photovoltaïque qui réduit les inconvénients des solutions de l'état de la technique.

Plus précisément, l'invention cherche à atteindre tout ou partie des objets suivants :
Un premier objet de l'invention est de proposer une solution de réalisation d'un conducteur électrique sur une cellule photovoltaïque permettant l'optimisation de la performance de la cellule photovoltaïque résultante.
Un second objet de l'invention est de proposer une solution de réalisation d'un conducteur électrique sur une cellule photovoltaïque par un procédé à forte productivité, performant et économique.

A cet effet, l'invention repose sur un système d'impression sérigraphique selon la revendication 1.

L'invention porte aussi sur une unité d'impression selon la revendication 10 et sur une unité de fabrication selon la revendication 11.

L'invention porte aussi sur un procédé selon la revendication 12 et aussi sur une utilisation selon la revendication 13.

L'invention est plus précisément définie par les revendications.

Ces objets, caractéristiques et avantages de la présente invention seront exposés en détail dans la description suivante de modes d'exécution particuliers faits à titre non-limitatif en relation avec les figures jointes parmi lesquelles :
La figure 1 illustre schématiquement les conducteurs à la surface d'une cellule photovoltaïque selon l'état de la technique.
La figure 2 représente schématiquement une vue en coupe d'un système d'impression sérigraphique à construction de type trampoline pour imprimer des conducteurs à la surface d'une cellule photovoltaïque selon un état de la technique.
La figure 3 représente schématiquement en vue de dessus le système d'impression sérigraphique à construction de type trampoline selon l'état de la technique.
La figure 4 représente schématiquement une vue en coupe perpendiculairement à l'axe X du système d'impression sérigraphique à construction de type trampoline selon l'état de la technique.
La figure 5 représente schématiquement une vue en coupe parallèlement à l'axe X du système d'impression sérigraphique à construction de type trampoline selon l'état de la technique.
La figure 6 représente une vue de dessus d'une partie d'un système d'impression sérigraphique selon un mode de réalisation de l'invention.
Les figures 7 à 9 représentent des vues de dessus d'une partie d'un système d'impression sérigraphique selon des variantes du mode de réalisation de l'invention.

Dans la description suivante, pour une raison de simplicité, les mêmes références seront utilisées sur les différentes figures pour désigner des éléments similaires, même si ces derniers peuvent présenter des formes et/ou propriétés différentes.

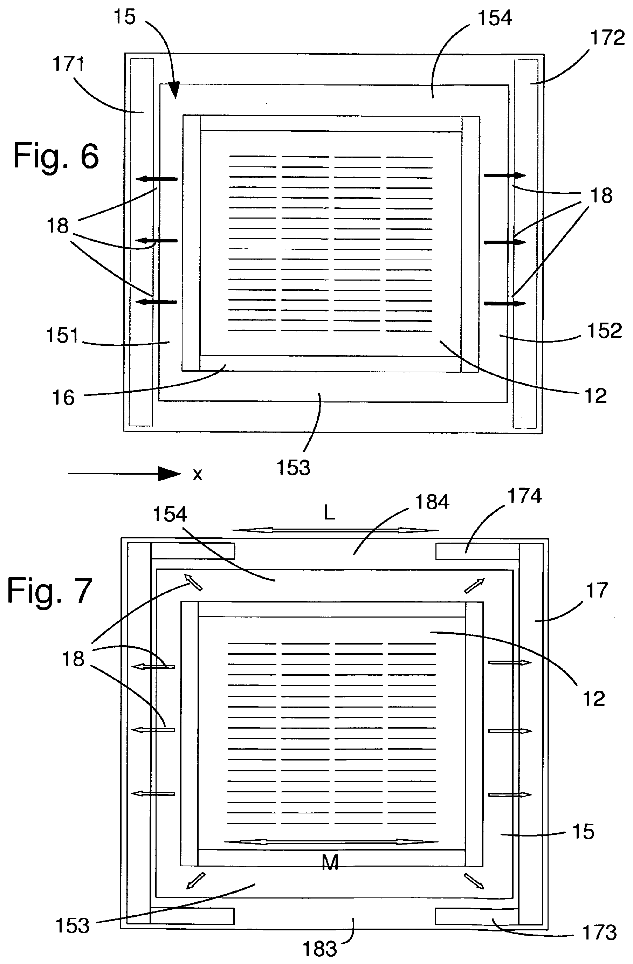

La figure 6 représente un mode de réalisation de l'invention, dans lequel le système d'impression sérigraphique repose aussi sur une construction de type trampoline. Il comprend ainsi un pochoir métallique 12 rectangulaire fixé à une toile 15 sur sa zone 16 de contour s'étendant sur les quatre côtés de sa périphérie rectangulaire, par collage ou tout dispositif de fixation. Toutefois, cette toile 15 n'est plus fixée à un cadre sur toute sa périphérie extérieure. En effet, seuls les deux côtés 151, 152 de cette toile, positionnés dans la direction perpendiculaire à la direction X de déplacement d'une racle sont fixés sur respectivement deux côtés 171, 172 d'un cadre 17 support par un dispositif de fixation quelconque 18, comme un collage. En revanche, les parties latérales 153, 154 de la toile présentent des extrémités libres, non fixées sur un cadre. Cette réalisation présente l'avantage de ne plus induire d'allongement du pochoir métallique 12 dans la direction latérale sous l'effet de la pression d'une racle, ce qui supprime les défauts d'impression causés par ce phénomène.

Dans cette solution, la toile 15 est donc fixée sur toute la périphérie du pochoir métallique, pour former un ensemble de type trampoline tel que décrit précédemment. Cet ensemble présente une partie de son contour périphérique libre, ce qui a pour effet de réduire ou supprimer la déformation du pochoir métallique lors de la fabrication du système d'impression et lors de son fonctionnement sous l'effet d'une racle. La toile 15 a pour effet de tendre le pochoir métallique sur le cadre support. Avec la géométrie retenue, l'effet de réduction ou suppression de la déformation du pochoir métallique est particulièrement obtenu dans la direction de déplacement de la racle.

La toile 15 périphérique est avantageusement constituée de fils tissés, pouvant être métalliques, mais de préférence organiques (polyester, polyamide, polyarylate), pour limiter le coût, et de préférence en polyester, pour plus de souplesse.

Les figures 7 à 9 illustrent quelques variantes de réalisation, sur lesquelles la toile 15 est fixée à un cadre 17 sur tout son contour périphérique à l'exception de deux zones au niveau des parties latérales opposées 153, 154 de la toile qui définissent respectivement des ouvertures 183, 184 entre la toile 15 et le cadre 17, plus précisément entre les parties latérales 153, 154 de la toile et les côtés 173, 174 en vis-à-vis du cadre 17. En variante, ces ouvertures 183, 184 sont simplement obtenues par des extrémités libres de la toile 15 en l'absence de cadre.

Dans ces variantes de réalisation, les ouvertures 183, 184 présentent une forme rectiligne, sensiblement parallèles aux montants extérieurs 173, 174 du cadre 17, et sensiblement dans le prolongement du motif à imprimer tel que défini par les ouvertures traversantes du pochoir métallique 12, de manière centrée par rapport à ces ouvertures traversantes. Elles ne s'étendent pas sur toute la longueur de la toile mais sur une longueur L sensiblement égale à la longueur M du motif à imprimer délimité par le pochoir métallique 12, cette longueur M se mesurant dans la direction sensiblement parallèle aux montants 173, 174 du cadre 17 et/ou aux côtés 153, 154 de la toile. En variante, les ouvertures présentent une longueur L différente, de préférence comprise entre M - 30 mm et M + 80 mm (L et M étant exprimés en mm). Avantageusement, ces ouvertures présentent une longueur L légèrement supérieure à la taille M du motif à imprimer, idéalement de l'ordre de M + 25 mm (soit par exemple une longueur de 170 mm des parties latérales 153, 154 de la toile présentent des extrémités libres, non fixées sur un cadre, pour des métallisations de 153 mm imprimées dans l'exemple d'une implémentation pour une longueur typique d'un motif imprimé sur une plaquette (wafer) de 156 mm, c'est à dire 6 pouces). Cette longueur L, de préférence inférieure à celle de la toile, c'est-à-dire à la longueur totale d'un côté 153, 154 de la toile 15, lui permet de garantir une légère tension latérale du pochoir métallique au niveau de ses extrémités.

En effet, il est avantageux de conserver un minimum de tension latérale afin que le pochoir métallique reste tendu dans les deux directions. C'est pourquoi il est souhaitable qu'une partie de la tension latérale transmise par la toile subsiste dans les extrémités. Il faut cependant qu'il n'y ait pas de tension latérale sur la partie du pochoir correspondant à la zone d'impression, afin d'éviter la déformation de celle-ci. Ainsi, les parties latérales 153, 154 de la toile présentant des extrémités libres, non fixées sur un cadre, par exemple au niveau d'ouvertures comme explicité ci-dessus, sont aménagées au niveau de cette zone d'impression du pochoir, et dimensionnées en fonction de la taille des ouvertures traversantes du pochoir qui définissent un motif à imprimer.

Les ouvertures 183, 184 peuvent être obtenues par différents procédés, par exemple par une absence de collage de la toile sur le cadre, ou par un collage traditionnel puis une découpe de la toile. De plus, selon une autre variante de réalisation, ces ouvertures ne sont pas droites, au contraire de l'exemple précédent, mais peuvent présenter des formes courbes.

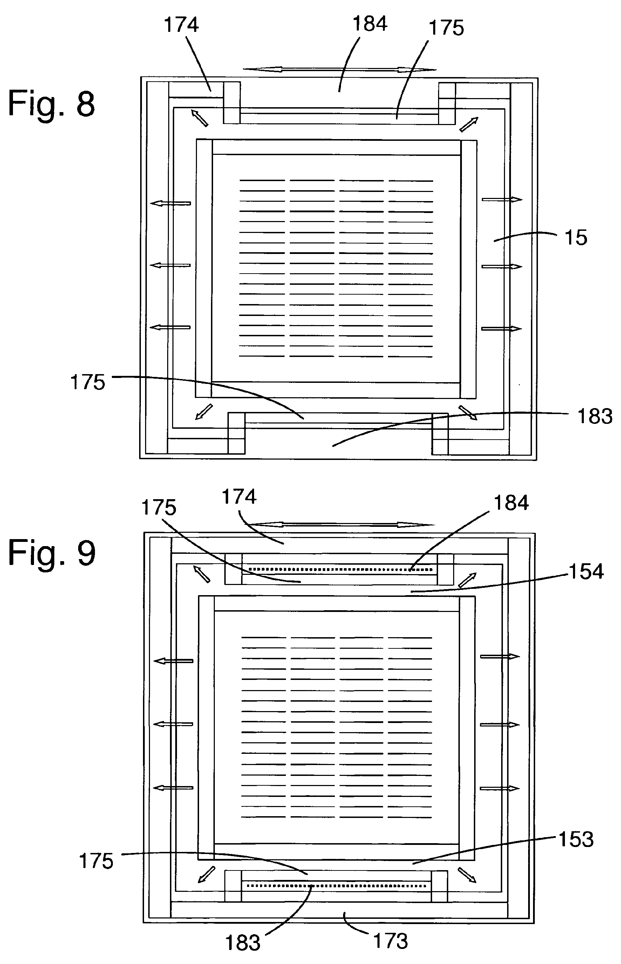

Les figures 8 et 9 illustrent des variantes dans lesquelles le cadre 17 présente une partie 175 au niveau des ouvertures 183, 184 entre la toile et le cadre, qui remplit la fonction de réduction du risque de filage des extrémités de la toile 15 au niveau de ces ouvertures. Cette partie 175 peut être obtenue par tout dépôt de type colle sur l'extrémité libre de la toile 15. Il est en effet souhaitable d'éviter que la toile ne file à partir de la zone non fixée au cadre, par exemple non collée, c'est-à-dire que des fils ne se détachent des parties latérales 153, 154 de la toile au niveau de ses extrémités libres. La zone libre de cette toile peut être avantageusement stabilisée en utilisant par exemple le même matériau de collage que celui utilisé pour le collage cadre/toile (ou pochoir métallique sur toile), mais en déportant le dépôt de cette colle vers l'intérieur afin qu'il ne soit pas en contact avec le cadre dans la zone voulue libre, comme cela est illustré par les parties 175 de la figure 8. En variante représentée par la figure 9, la toile 15 pourrait d'abord être collée au cadre 17 sur les quatre côtés puis redécoupées dans une zone à l'intérieur du cadre, un cordon de colle supplémentaire étant rajouté sur la toile vers l'intérieur entourant ainsi la partie de toile à découper pour éviter le filage au niveau des ouvertures 183, 184 finalement obtenues.

En variante non représentée, le système d'impression sérigraphique comprend un pochoir métallique rectangulaire fixé à une toile sur une zone réduite, ne s'étendant plus sur les quatre côtés de sa périphérie rectangulaire. En effet, seuls les deux côtés de ce pochoir, positionnés dans une direction perpendiculaire à la direction X de déplacement d'une racle, sont fixés sur respectivement deux côtés d'une toile périphérique par respectivement un dispositif de fixation comme un collage. En revanche, les parties latérales du pochoir métallique restent libres, non fixées à la toile ou au cadre. La toile reste fixée au cadre sur toute sa périphérie, sur ses quatre côtés.

L'invention a été décrite par des modes de réalisations particuliers, à titre d'exemple. Elle s'applique plus généralement à tout système d'impression sérigraphique comprenant un pochoir métallique caractérisé en ce qu'une toile fixée au pochoir métallique présente au moins une extrémité libre, pour réduire ou supprimer sa déformation sous l'effet d'une racle. Ainsi, le pochoir et la toile peuvent comprendre d'autres formes et dimensions que celles décrites précédemment, présenter des extrémités libres différentes de celles décrites, sur une longueur inférieure ou supérieure par exemple et/ou un nombre différent d'extrémités libres.

Finalement, l'invention porte donc aussi sur un procédé de fabrication d'un système d'impression sérigraphique, caractérisé en ce qu'il comprend la fixation d'une toile fixée au pochoir métallique de sorte à lui laisser au moins une extrémité libre, pour réduire ou supprimer sa déformation sous l'effet d'une racle.

L'invention porte aussi sur un procédé de réalisation d'un conducteur électrique sur une plaque à l'aide d'un système d'impression tel que décrit précédemment, caractérisé en ce qu'il comprend l'étape d'impression au travers du pochoir pour déposer une couche d'encre conductrice sur la surface de la plaque, de sorte de former plusieurs conducteurs, à l'aide d'une racle pressant cette encre dans les ouvertures de la partie centrale du pochoir et induisant un déplacement d'une extrémité libre d'une toile fixée au pochoir métallique.

Ce procédé d'impression est particulièrement intéressant pour un procédé de fabrication d'un dispositif photovoltaïque, pour former tout ou partie des conducteurs de surface comme les conducteurs de collecte et/ou les conducteurs de type bus barres.

Notamment, l'impression peut permettre de former des premiers conducteurs selon une première direction, ces conducteurs étant discontinus, interrompus au niveau d'au moins une zone d'interconnexion, avant la réalisation d'une liaison électrique en recouvrant les zones d'interconnexion des premiers conducteurs par au moins un second conducteur. Cette dernière étape est avantageusement obtenue par la fixation d'un ruban métallique par soudure ou collage.

L'invention porte aussi sur une unité de fabrication de dispositifs photovoltaïques, caractérisée en ce qu'elle comprend un système d'impression sérigraphique tel que décrit précédemment pour mettre en oeuvre ce procédé d'impression de conducteurs.

## Revendications

1. Système d'impression sérigraphique comprenant un pochoir métallique (12), et une toile (15) fixée sur toute la périphérie de ce pochoir métallique (12) pour former un ensemble trampoline et présentant au moins une extrémité libre, pour réduire ou supprimer la déformation sous l'effet d'une racle (20), **caractérisé en ce que** le pochoir métallique (12) est rectangulaire, et **en ce que** l'extrémité libre de la toile (15) fixée au pochoir métallique (12) comprend tout ou partie des extrémités des deux côtés latéraux (153, 154) de la toile orientés dans la direction parallèle à la direction de déplacement de la racle (20) du système d'impression.

2. Système d'impression sérigraphique selon la revendication précédente, **caractérisé en ce que** la toile (15) présente une partie de son contour périphérique libre, par non fixation sur un cadre support (17) et/ou par l'intermédiaire d'au moins une ouverture (183 ; 184) réalisée au niveau de son contour.

3. Système d'impression sérigraphique selon l'une des revendications précédentes, **caractérisé en ce que** la toile (15) comprend des fils tissés comportant au moins l'un des éléments du groupe comportant des fils métalliques, des fils organiques de type polyester, des fils organiques de type polyamide, des fils organiques de type polyacrylate.

4. Système d'impression sérigraphique selon l'une des revendications précédentes, **caractérisé en ce que** les deux autres côtés (151, 152) de la toile (15) fixée au pochoir métallique (12), orientés dans la direction perpendiculaire à la direction de déplacement de la racle (20) du système d'impression, sont fixés à un cadre (17) support.

5. Système d'impression sérigraphique selon l'une des revendications précédentes, **caractérisé en ce que** la toile (15) comprend au moins une extrémité libre agencée sur un côté (153, 154) de la toile et **en ce que** la longueur L de cette extrémité libre est inférieure à la longueur dudit côté de la toile pour conserver une tension exercée dans deux directions.

6. Système d'impression sérigraphique selon l'une des revendications précédentes, **caractérisé en ce que** le pochoir métallique (12) comprend des ouvertures traversantes définissant un motif à imprimer de longueur M (en mm) mesurée dans la direction d'une extrémité libre de la toile (15), cette extrémité libre présentant une longueur L (en mm) comprise entre M - 30 mm et M + 80 mm.

7. Système d'impression sérigraphique selon l'une des revendications 1 à 5, **caractérisé en ce que** le pochoir métallique (12) comprend des ouvertures traversantes définissant un motif à imprimer de longueur M mesurée dans la direction d'une extrémité libre de la toile (15), cette extrémité libre présentant une longueur L supérieure à la longueur M dudit motif.

8. Système d'impression sérigraphique selon l'une des revendications 6 et 7, **caractérisé en ce que** l'extrémité libre de la toile (15) est sensiblement centrée par rapport au motif à imprimer défini par les ouvertures traversantes du pochoir métallique (12).

9. Système d'impression sérigraphique selon l'une des revendications précédentes, **caractérisé en ce qu'**il comprend un dépôt de type colle au niveau d'au moins une partie d'une extrémité libre de la toile (15) pour éviter son filage.

10. Unité d'impression de conducteurs sur un dispositif photovoltaïque comportant un système d'impression sérigraphique selon l'une des revendications précédentes.

11. Unité de fabrication de dispositifs photovoltaïques, **caractérisée en ce qu'**elle comprend une unité d'impression de conducteurs sur un dispositif photovoltaïque selon la revendication 10.

12. Procédé d'impression sérigraphique à partir d'un système d'impression sérigraphique selon l'une des revendications 1 à 9, **caractérisé en ce qu'**il comprend une étape de raclage du pochoir induisant un déplacement d'une extrémité libre d'une toile (15) fixée au pochoir métallique (12).

13. Utilisation d'un système d'impression sérigraphique selon l'une des revendications 1 à 9 pour la fabrication d'un dispositif photovoltaïque, **caractérisé en ce qu'**il comprend une étape d'impression sérigraphique de conducteurs sur une plaquette silicium à l'aide du système d'impression sérigraphique.

## Patentansprüche

1. Siebdrucksystem, umfassend eine Metallschablone (12) und eine Leinwand (15), die auf der gesamten Peripherie dieser Metallschablone (12) befestigt ist, um eine Trampolineinheit zu bilden, und mindestens ein freies Ende aufweisend, um die Verformung unter der Wirkung einer Rakel (20) zu verringern oder zu beseitigen, **dadurch gekennzeichnet, dass** die Metallschablone (12) rechteckig ist, und dass das freie Ende der Leinwand (15), das an der Metallschablone (12) befestigt ist, die Gesamtheit oder einen Teil der Enden der beiden Seiten (153, 154) der Leinwand, die in die Richtung parallel zur Bewegungsrichtung des Rakels (20) des Drucksystems gerichtet sind, umfasst.

2. Siebdrucksystem nach dem vorhergehenden Anspruch, **dadurch gekennzeichnet, dass** die Leinwand (15) einen freien Teil ihrer Umfangskontur durch Nichtbefestigung auf einem Tragrahmen (17) und/oder mit Hilfe mindestens einer Öffnung (183; 184), die im Bereich seiner Kontur ausgeführt ist, aufweist.

3. Siebdrucksystem nach einem der vorhergehenden Ansprüche, **dadurch gekennzeichnet, dass** die Leinwand (15) ein Drahtgewebe aufweist, umfassend mindestens eines der Elemente der Gruppe, umfassend metallische Gewebe, organische Gewebe vom Typ Polyester, organische Gewebe vom Typ Polyamid, organische Gewebe vom Typ Polyacrylat.

4. Siebdrucksystem nach einem der vorhergehenden Ansprüche, **dadurch gekennzeichnet, dass** die beiden anderen Seiten (151, 152) der Leinwand (15), die an der Metallschablone (12) befestigt ist, die in die Richtung senkrecht auf die Bewegungsrichtung der Rakel (20) des Drucksystems gerichtet sind, an einem Tragrahmen (17) befestigt sind.

5. Siebdrucksystem nach einem der vorhergehenden Ansprüche, **dadurch gekennzeichnet, dass** die Leinwand (15) mindestens ein freies Ende umfasst, das auf einer Seite (153, 154) der Leinwand angeordnet ist, und dass die Länge L dieses freien Endes kleiner als die Länge der Seite der Leinwand ist, um eine in zwei Richtungen ausgeübte Spannung zu bewahren.

6. Siebdrucksystem nach einem der vorhergehenden Ansprüche, **dadurch gekennzeichnet, dass** die Metallschablone (12) durchgehende Öffnungen umfasst, die ein zu druckendes Motiv der Länge M (in mm), gemessen in die Richtung eines freien Endes der Leinwand (15), definiert, wobei dieses freie Ende eine Länge L (in mm) zwischen M -30 mm und M +80 mm aufweist.

7. Siebdrucksystem nach einem der Ansprüche 1 bis 5, **dadurch gekennzeichnet, dass** die Metallschablone (12) durchgehende Öffnungen umfasst, die ein zu druckendes Motiv mit einer Länge M, gemessen in die Richtung eines freien Endes der Leinwand (15), definieren, wobei dieses freie Ende eine Länge L größer als die Länge M des Motivs aufweist.

8. Siebdrucksystem nach einem der Ansprüche 6 und 7, **dadurch gekennzeichnet, dass** das freie Ende der Leinwand (15) im Wesentlichen in Bezug auf das zu druckende Motiv, das durch die durchgehenden Öffnungen der Metallschablone (12) definiert ist, zentriert ist.

9. Siebdrucksystem nach einem der vorhergehenden Ansprüche, **dadurch gekennzeichnet, dass** es einen Auftrag vom Typ Klebstoff im Bereich mindestens eines Teils eines freien Endes der Leinwand (15) umfasst, um ihr Verspinnen zu vermeiden.

10. Einheit zum Drucken von Leitern auf eine Photovoltaikvorrichtung, umfassend ein Siebdrucksystem nach einem der vorhergehenden Ansprüche.

11. Einheit zur Herstellung von Photovoltaikvorrichtungen, **dadurch gekennzeichnet, dass** sie eine Einheit zum Drucken von Leitern auf eine Photovoltaikvorrichtung nach Anspruch 10 umfasst.

12. Siebdruckverfahren auf Basis eines Siebdrucksystems nach einem der Ansprüche 1 bis 9, **dadurch gekennzeichnet, dass** es einen Schritt des Abstreifens der Schablone umfasst, der zu einer Verschiebung eines freien Endes einer an der Metallschablone (12) befestigten Leinwand (15) führt.

13. Verwendung eines Siebdrucksystems nach einem der Ansprüche 1 bis 9 für die Herstellung einer Photovoltaikvorrichtung, **dadurch gekennzeichnet, dass** es einen Schritt des Siebdruckens von Leitern auf eine Siliziumplakette mit Hilfe des Siebdrucksystems umfasst.

## Claims

1. Screen-printing system comprising a metal stencil (12), and a cloth (15) fixed to the entire periphery of said metal stencil (12) to form a trampoline assembly and having at least one free end, in order to decrease or prevent deformation under the effect of a doctor blade (20), **characterized in that** the metal stencil (12) is rectangular, and **in that** the free end of the cloth (15) fixed to the metal stencil (12) comprises all or a portion of the ends of those two lateral sides (153, 154) of the cloth which are oriented in the direction parallel to the movement direction of the doctor blade (20) of the printing system.

2. Screen-printing system according to the preceding claim, **characterized in that** a portion of the peripheral edge of the cloth (15) is left free, by not fastening it to a supporting frame (17) and/or by way of at least one aperture (183; 184) produced at its edge.

3. Screen-printing system according to one of the preceding claims, **characterized in that** the cloth (15) comprises woven threads comprising at least one of the elements of the group comprising metal threads, organic threads such as polyester, organic threads such as polyamide, organic threads such as polyacrylate.

4. Screen-printing system according to one of the preceding claims, **characterized in that** the two other sides (151, 152) of the cloth (15) fixed to the metal stencil (12), which sides are oriented in the direction perpendicular to the movement direction of the doctor blade (20) of the printing system, are fixed to a supporting frame (17).

5. Screen-printing system according to one of the preceding claims, **characterized in that** the cloth (15) comprises at least one free end arranged on one side (153, 154) of the cloth, and **in that** the length L of this free end is smaller than the length of said side of the cloth in order to maintain a tension exerted in two directions.

6. Screen-printing system according to one of the preceding claims, **characterized in that** the metal stencil (12) comprises through-apertures defining a pattern to be printed of length M (in mm) measured in the direction of a free end of the cloth (15), this free end having a length L (in mm) comprised between M-30 mm and M+80 mm.

7. Screen-printing system according to one of Claims 1 to 5, **characterized in that** the metal stencil (12) comprises through-apertures defining a pattern to be printed of length M measured in the direction of a free end of the cloth (15), this free end having a length L larger than the length M of said pattern.

8. Screen-printing system according to either one of Claims 6 and 7, **characterized in that** the free end of the cloth (15) is substantially centred with respect to the pattern to be printed, which pattern is defined by the through-apertures in the metal stencil (12).

9. Screen-printing system according to one of the preceding claims, **characterized in that** it comprises an adhesive type deposit on at least a portion of a free end of the cloth (15) to prevent it from running.

10. Printing unit for conductors on a photovoltaic device comprising a screen-printing system according to one of the preceding claims.

11. Unit for manufacturing photovoltaic devices, **characterized in that** it comprises a printing unit for conductors on a photovoltaic device according to claim 10.

12. Screen-printing process using a screen-printing system according to one of Claims 1 to 9, **characterized in that** it comprises a step of doctoring the stencil causing a free end of a cloth (15) fixed to the metal stencil (12) to move.

13. Use of a screen-printing system according to one of claims 1 to 9 for the manufacture of a photovoltaic device, **characterized in that** it comprises a step of screen printing conductors on a silicon wafer using the screen-printing system.
